(19) Europäisches Patentamt
European Patent Office
Office européen des brevets

(11) EP 2 813 599 A1

(12) **EUROPEAN PATENT APPLICATION**
published in accordance with Art. 153(4) EPC

(43) Date of publication:
**17.12.2014 Bulletin 2014/51**

(21) Application number: **13746660.3**

(22) Date of filing: **07.02.2013**

(51) Int Cl.:
***C23C 16/455*** *(2006.01)* ***C01B 31/02*** *(2006.01)*
***C23C 16/27*** *(2006.01)*

(86) International application number:
**PCT/JP2013/052868**

(87) International publication number:
**WO 2013/118822 (15.08.2013 Gazette 2013/33)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **10.02.2012 JP 2012027080**

(71) Applicant: **JTEKT Corporation**
**Osaka-shi, Osaka 542-8502 (JP)**

(72) Inventors:
- **SUZUKI, Masahiro**
  **Osaka-shi**
  **Osaka 542-8502 (JP)**
- **YAMAKAWA, Kazuyoshi**
  **Osaka-shi**
  **Osaka 542-8502 (JP)**
- **SAITO, Toshiyuki**
  **Osaka-shi**
  **Osaka 542-8502 (JP)**

(74) Representative: **TBK**
**Bavariaring 4-6**
**80336 München (DE)**

# (54) DEVICE FOR FORMING CARBON FILM AND METHOD FOR FORMING CARBON FILM

(57) A carbon film deposition apparatus includes a nozzle which has a plurality of outlets for discharging source gas into a process chamber, and which includes a gas introduction pipe defining therein a gas flow path communicating with each of the plurality of outlets. A portion of a pipe wall of the gas introduction pipe corresponding to formation regions of the plurality of outlets is formed to have a stepped shape such that diameters of the gas flow path of the pipe wall become smaller as a distance from a side of supply of source gas by source gas supply means increases.

*FIG. 4*

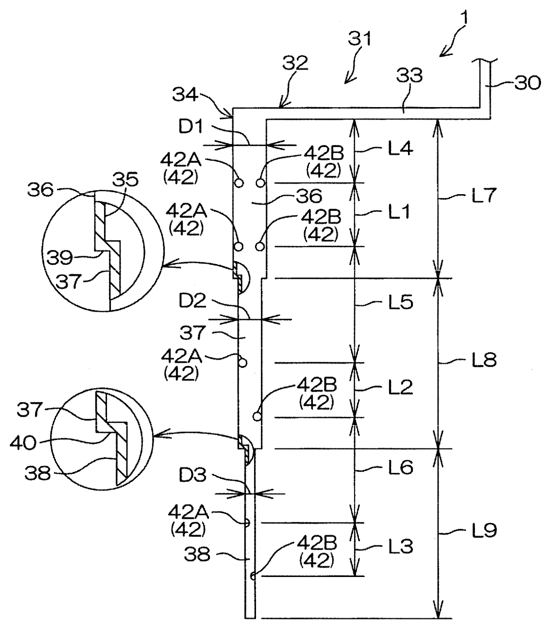


EP 2 813 599 A1

## Description

### Technical Field

This invention relates to a carbon film deposition apparatus and a carbon film deposition method for depositing a carbon film such as a DLC (Diamond-Like Carbon) film on a surface of a base material.

### Background Art

Conventionally, a known method for depositing a carbon film such as a DLC film is a plasma CVD (Plasma Chemical Vapor Deposition) method such as a DC pulse plasma CVD method or a DC plasma CVD method (for example, see Patent Document 1).

The plasma CVD method is implemented by, for example, the following plasma CVD film deposition apparatus. The plasma CVD film deposition apparatus includes, for example, a process chamber, a base table stored in the process chamber, source gas supply means for introducing source gas into the process chamber, and a plasma power source for generating a DC voltage (DC pulse voltage) for changing the source gas introduced into the process chamber into a plasma state.

### Related Art Documents

### Patent Documents

Patent Document 1: JP-A-2011-252179

### Summary of the Invention

### Problem to be Solved by the Invention

The present inventor et al. consider that long gas introduction pipe extending from the upward side to the downward side inside the process chamber is adopted as the source gas supply means of such a plasma CVD film deposition apparatus. In a peripheral surface of the gas introduction pipe, outlets for discharging source gas into the process chamber are arranged along a longitudinal direction of the gas introduction pipe. These outlets are arranged at substantially the same density.

As a result of conducting experiments using the plasma CVD film deposition apparatus in which such gas introduction pipe is adopted, the present inventor et al. obtained knowledge that a film deposition rate of a surface of the base material lower portion located under the process chamber was high but a film deposition rate of a surface of the base material upper portion located over the process chamber was low. Because of that, a film thickness of the base material lower portion may become thicker than a film thickness of the base material upper portion when the film is deposited with the surface of the base material arranged sideward. As this cause, a source gas concentration in a lower region of the inside of the process chamber probably becomes high while a source gas concentration in an upper region of the inside of the process chamber becomes low. In other words, as the cause, a discharge flow rate of source gas from each outlet of the downstream side of the gas introduction pipe is probably high while a discharge flow rate of source gas from each outlet of the upstream side of the gas introduction pipe is low.

An object of this invention is to provide a carbon film deposition apparatus and a carbon film deposition method capable of depositing a carbon film with a uniform thickness by equalize a source gas concentration in each place of an inside of a process chamber.

### Means for Solving the Problem

In a first aspect of the invention, there is provided a carbon film deposition apparatus for depositing a carbon film on a surface of a base material, including: a process chamber; base material holding means which is stored in the process chamber and which holds the base material; a nozzle which has a plurality of outlets for discharging source gas into the process chamber, and which includes a gas introduction pipe defining therein a gas flow path communicating with each of the plurality of outlets; and source gas supply means for supplying the source gas containing a carbon-based compound to the gas introduction pipe, wherein a portion of a pipe wall of the gas introduction pipe corresponding to formation regions of the plurality of outlets is formed to have a stepped shape such that diameters of the gas flow path of the pipe wall become smaller as a distance from a side of supply of source gas by the source gas supply means increases.

## Advantages of the Invention

According to the above-described aspect of the invention, the source gas concentration can be equalized in each place of the inside of the process chamber, whereby it is possible to provide a carbon film deposition apparatus and a carbon film deposition method capable of depositing a carbon film with a uniform thickness.

## Brief Description of the Drawings

Fig. 1 is a diagram schematically showing a configuration of a plasma CVD film formation apparatus according to an embodiment of the invention.
Fig. 2 is a perspective view showing a configuration of a gas introduction mechanism and a base table shown in Fig. 1.
Fig. 3 is a diagram viewed from cut plane line III-III shown in Fig. 1.
Fig. 4 is a schematic diagram showing a configuration of a gas introduction nozzle shown in Fig. 1.
Fig. 5 is a graph showing one example of a waveform of a DC pulse voltage applied to a base material from a plasma power source of the plasma CVD film deposition apparatus shown in Fig. 1.
Fig. 6 is a sectional view of a surface layer portion of a surface of a coating member.
Fig. 7 is a schematic diagram showing a configuration of a gas introduction nozzle of a plasma CVD film deposition apparatus of Comparative Example 1.
Fig. 8 is a diagram showing base material height direction distribution of film thicknesses of DLC films deposited by the plasma CVD film deposition apparatuses of Example 1 and Comparative Example 1.

## Mode for Carrying Out the invention

An embodiment of the invention will hereinafter be described with reference to the accompanying drawings.

Fig. 1 is a diagram schematically showing a configuration of a plasma CVD film deposition apparatus according to the embodiment of the invention. A coating member 20 (see Fig. 6) can be manufactured by depositing a DLC film on a surface (peripheral surface) 201 of a base material 200 by a DC pulse plasma CVD method using a plasma CVD film deposition apparatus 1.

The plasma CVD film deposition apparatus 1 includes a process chamber 3 with a rectangular parallelepiped (or a cube) surrounded by a partition wall 2, a base table (base material holding means) 5 for supporting the base material 200 by abutting from the downward side, a gas introduction mechanism 6 for introducing source gas which is component gas into the process chamber 3, an exhaust system 7 for evacuating the inside of the process chamber 3, and a plasma power source 8 for generating a DC pulse voltage for changing the gas introduced into the process chamber 3 into a plasma state. The plasma CVD film deposition apparatus 1 is an apparatus for implementing a DC pulse plasma CVD (Direct Current Plasma Chemical Vapor Deposition) method.

The base table 5 includes a disk-shaped plate 9 (see Figs. 2 and 3 together) having a horizontal placement surface, and a support shaft 10 for supporting the plate 9 extending vertically. In Fig. 1, a one-step type having only one plate 9 is adopted as the base table 5, but multiple-step (for example, two-step) type having a plurality of plates 9 vertically arranged may also be adopted as the base table 5. The base table 5 is generally formed using a conductive material such as steel. A negative electrode of the plasma power source 8 is connected to the base table 5. The base material 200 is placed on the plate 9.

Also, the partition wall 2 of the process chamber 3 is formed using a conductive material such as stainless steel. A positive electrode of the plasma power source 8 is connected to the partition wall 2. Also, the partition wall 2 is connected to the earth. Also, the partition wall 2 is insulated from the base table 5 by an insulating member 11. As a result, the partition wall 2 is maintained at an earth potential. When the plasma power source 8 is turned on and a DC pulse voltage is generated, a potential difference occurs between the partition wall 2 and the base table 5.

The exhaust system 7 includes: a first exhaust pipe 13 and a second exhaust pipe 14 each communicating with the inside of the process chamber 3; a first opening/closing valve 15; a second opening/closing valve 16; a third opening/closing valve 19; a first pump 17; and a second pump 18.

The first opening/closing valve 15 and the first pump 17 are interposed in the first exhaust pipe 13 in this order from the side of the process chamber 3. As the first pump 17, for example, a low-vacuum pump such as an oil-sealed rotary vacuum pump (rotary pump) or a diaphragm vacuum pump is adopted. The oil-sealed rotary vacuum pump is a positive-displacement vacuum pump for decreasing ineffective space and airtight space between components such as a rotor, a stator and a sliding blade by oil. The oil-sealed rotary vacuum pump adopted as the first pump 17 includes a rotary vane oil-sealed rotary vacuum pump or a swing piston vacuum pump.

Also, the top of the second exhaust pipe 14 is connected between the first opening/closing valve 15 and the first pump 17 in the first exhaust pipe 13. The second opening/closing valve 16, the second pump 18 and the third opening/closing valve 19 are interposed in the second exhaust pipe 14 in this order from the side of the process chamber 3. As the second pump 18, for example, a high-vacuum pump such as a turbo-molecular pump or an oil-diffusion pump is adopted.

The gas introduction mechanism 6 includes collecting pipe 30, a plurality of component gas introduction pipe (not shown) connected to the upstream side of the collecting pipe 30, and a plurality of (four in this embodiment) gas introduction nozzles (nozzles) 31 branched and connected to the downstream side of the collecting pipe 30. The collecting pipe 30 is arranged on a central axis line of the disk-shaped plate 9 along the central axis line. The component gas from a supply source (for example, a gas cylinder or a container for storing liquid) of the corresponding component gas is supplied to each component gas introduction pipe. One of the plurality of component gases is, for example, gas including a carbon-based compound. Each component gas introduction pipe is provided with, for example, a flow rate regulating valve (not shown) for regulating a flow rate of the component gas from each supply source. Also, the container for storing liquid in the supply sources is provided with heating means (not shown) for heating the liquid as necessary. The collecting pipe 30, the plurality of component gas introduction pipe (not shown), the supply source (not shown) of each component gas, etc. are included in one example of "source gas supply means".

Fig. 2 is a perspective view showing a configuration of the gas introduction mechanism 6 and the base table 5. Fig. 3 is a diagram viewed from cut plane line III-III shown in Fig. 1. Fig. 4 is a schematic diagram showing a configuration of the gas introduction nozzle 31.

The plurality of gas introduction nozzles 31 are formed mutually rotationally symmetrically about the collecting pipe 30, and are formed at an equiangular distance (for example, a distance of 90°). The plurality of gas introduction nozzles 31 have the same specifications.

Each of the gas introduction nozzles 31 includes each gas introduction pipe 32 connected to the downstream end of the collecting pipe 30. Each gas introduction pipe 32 includes a horizontal part 33 connected to the downstream end of the collecting pipe 30 and horizontally extending from the downstream end toward the radial outward side (direction away from the collecting pipe 30) of the base table 5, and a vertical part 34 connected to the downstream end (lateral end) of the horizontal part 33 and drooping from the lateral end toward the vertical downward side, and is formed in a generally L shape overturned 180°. In other words, the plurality of (for example, four) horizontal parts 33 extend radially from the downstream end of the collecting pipe 30.

Each gas introduction pipe 32 (each vertical part 34 and each horizontal part 33) is formed in a cylindrical shape. A cylindrical gas flow path 35 communicating with the inside of the collecting pipe 30 is defined in each gas introduction pipe 32. Each gas flow path 35 is closed in the downstream end of each vertical part 34. Also, the following outlet is not formed in each horizontal part 33.

As shown in Fig. 3, the vertical parts 34 are respectively arranged in four corners of a rectangular shape in plan view in the process chamber 3. The downstream end of each gas introduction nozzle 31, that is, the downstream end of each vertical part 34 is located in the lateral side of the base table 5.

The vertical part 34 includes a first portion 36, a second portion 37 and a third portion 38 with mutually different pipe diameters in order from the side of the collecting pipe 30 (the side of the horizontal part 33). The pipe diameter and thickness of each of the pipe walls of the first portion 36, the second portion 37 and the third portion 38 is constant in a direction of the pipe axis. A relation among an outside diameter D1 of the first portion 36, an outside diameter D2 of the second portion 37 and an outside diameter D3 of the third portion 38 is $D1>D2>D3$. In other words, the pipe wall of the first portion 36, the pipe wall of the second portion 37 and the pipe wall of the third portion 38 are formed to have a stepped shape such that the diameters of the pipe walls become smaller toward the downstream side. The downstream end of the first portion 36 is connected to the upstream end of the second portion 37 by an annular first step part (a step portion of the pipe wall) 39 having a horizontal attitude. Also, the downstream end of the second portion 37 is connected to the upstream end of the third portion 38 by an annular second step part (a step portion of the pipe wall) 40 having a horizontal attitude. In addition, the lengths L7, L8, L9 of the first portion 36, the second portion 37 and the third portion 38, respectively, in the direction of the pipe axis are set substantially equally.

As shown in Fig. 4, a plurality of (for example, eight) outlets 42 for discharging source gas are formed in a peripheral surface of each vertical part 34. Concretely, in each of the first, second and third portions 36, 37, 38, the outlets 42 are arranged along the direction of the pipe axis. The plurality of outlets 42 are arranged at substantially the same density, and each of the outlets 42 has mutually substantially the same size and is opened in the pipe walls of the first, second and third portions 36, 37, 38 (through the inside and the outside of the pipe wall). In other words, the outlet 42 communicates with the gas flow path 35.

The outlets 42 have a first outlet 42A for discharging source gas toward a predetermined first transverse direction (first discharge direction), and a second outlet 42B for discharging the source gas toward a second transverse direction (second discharge direction) 90° out of phase with the first transverse direction in a circumferential direction of the cylindrical vertical part 34. The first transverse direction is an inward transverse direction (horizontal direction) along one side surface of two side surfaces of the partition wall 2 forming the corners in which the vertical parts 34 are stored, and the second transverse direction is an inward transverse direction (horizontal direction) along the other side surface of two side surfaces of the partition wall 2 forming the corners in which the vertical parts 34 are stored.

In the vertical part 34, a pair of outlets 42A, 42B made of the first outlet 42A and the second outlet 42B is arranged in the same position of the direction of the pipe axis in the first portion 36. In the first portion 36, two pairs of outlets 42A, 42B are vertically spaced by a distance L1. Also, in the second portion 37, the first outlet 42A and the second outlet 42B are mutually spaced in the upstream side and the downstream side by a distance L2. In the third portion 38, the first outlet 42A and the second outlet 42B are mutually spaced in the upstream side and the downstream side by a distance L3.

Also, a pair of outlets 42A, 42B of the upstream side in the first portion 36 is spaced by a distance L4 from the downstream end of the horizontal part 33, and the outlet 42 (first outlet 42A) of the upstream side in the second portion 37 is spaced by a distance L5 from a pair of outlets 42A, 42B of the downstream side in the first portion 36. The outlet 42 (first outlet 42A) of the upstream side in the third portion 38 is spaced by a distance L6 from the outlet 42 (second outlet 42B) of the downstream side in the second portion 37.

The pipe wall of the vertical part 34 formed to have a stepped shape such that the diameters of the gas flow path of the pipe wall become smaller as a distance from the side of supply of source gas increases. Because of that, the first and second step parts 39, 40 interfere with the source gas passing through the gas flow path 35. As a result, the gas can be caused to overflow to the upstream side of the gas flow path 35 and also, the source gas is inhibited from being supplied to the downstream side of the gas flow path 35. Accordingly, a discharge flow rate of the source gas from each of the outlets 42 can be made uniform, with the result that a source gas concentration in each place of the inside of the process chamber 3 can be made uniform. Hence, a DLC film 21 with a uniform thickness can be deposited on the surface 201 of the base material 200.

Also, the outlet is not formed in the horizontal part 33, and the outlets 42 are formed in only the vertical part 34. Since the outlet is not formed in the horizontal part 33, a pressure of the source gas in each place of the vertical part 34 (particularly, the upstream portion of the vertical part 34) can be maintained high and the source gas can be discharged from all the outlets 42 in a rushing manner.

Further, since the first and second outlets 42A, 42B with mutually different discharge directions are formed as the outlets 42, the source gas can evenly be spread in each place of the inside of the process chamber 3 even when the number of gas introduction nozzles 31 stored and arranged in the process chamber 3 is small. Accordingly, the source gas concentration in each place of the inside of the process chamber 3 can be made more uniform. In addition, the discharge directions and arrangement of such outlets 42 are one example, and can be changed properly.

Next, process for manufacturing the coating member 20 (see Fig. 6) by depositing the DLC film 21 (see Fig. 6) as one example of a carbon film on the surface 201 of the base material 200 using the plasma CVD film deposition apparatus 1 will be described with reference to Fig. 1 etc.

First, the base material 200 is carried into the process chamber 3, and the base material 200 is placed on the plate 9 of the base table 5 in an attitude in which the surface 201 (peripheral surface) is turned laterally, and the base material 200 is supported on an upper surface of the plate 9 (a base material holding step).

Then, the inside of the process chamber 3 is evacuated by opening the first opening/closing valve 15 after the first pump 17 is driven with the first, second and third opening/closing valves 15, 16, 19 closed. At a point in time when the inside of the process chamber 3 is evacuated to a predetermined degree of vacuum by the first pump 17, the first opening/closing valve 15 is closed and also the third opening/closing valve 19 is opened and the second pump 18 is driven and then the second opening/closing valve 16 is opened and thereby, the inside of the process chamber 3 is further evacuated by the first and second pumps 17, 18.

At a point in time when the inside of the process chamber 3 reaches the predetermined degree of vacuum, the second opening/closing valve 16 is closed and the second pump 18 is stopped and the third opening/closing valve 19 is closed and also and the first opening/closing valve 15 is opened and while continuing exhaust by only the first pump 17, source gas is supplied from the supply source (not shown) to each of the gas introduction nozzles 31 through the collecting pipe 30, and this source gas is introduced into the process chamber 3 through each of the outlets 42. First, the source gas introduced into the process chamber 3 is, for example, hydrogen gas and argon gas. The hydrogen gas and the argon gas have action of stabilizing plasma. The source gas is not limited to the hydrogen gas and the argon gas, and may be only the argon gas.

Then, the power source 8 is turned on and a negative DC pulse voltage (for example, -1000 V) is applied to the base table 5. Accordingly, a potential difference occurs between the partition wall 2 and the base table 5, and plasma is generated inside the process chamber 3. This plasma generation produces ions or radicals from the source gas inside the process chamber 3 and also, the ions or radicals are implanted in the surface 201 of the base material 200 based on the potential difference, and fine unevenness (atomic-level unevenness) is formed on the surface 201 of the base material 200 (a sputter step). Also, by implanting the ions or radicals in the surface 201 of the base material 200, different molecules etc. adsorbed on the surface 201 of the base material 200 can be eliminated by sputtering, or the surface 201 can be activated, or atomic arrangement etc. can be modified (ion bombardment process).

When a predetermined process time has elapsed since the power source 8 was turned on, supply of the source gas (hydrogen gas and argon gas) to the process chamber 3 is stopped. Then, with the inside of the process chamber 3 evacuated, the source gas is supplied from the supply source (not shown) to each of the gas introduction nozzles 31 through the collecting pipe 30, and this source gas is introduced into the process chamber 3 through each of the outlets 42. The source gas introduced into the process chamber 3 at this time is, for example, gas including Si (for example, $H_2$, TMS (tetramethylsilane gas ($Si(CH_3)_4$)), and mixed gas of $CH_4$ (methane)). Then, a negative DC pulse voltage is applied to the base table 5 while this source gas is introduced into the process chamber 3. Accordingly, plasma is generated inside the process chamber 3 to thereby form an intermediate layer 22 with which the surface 201 of the base material 200 is covered (an intermediate layer forming step).

When a predetermined process time has elapsed since the power source 8 was turned on, supply of the source gas to the process chamber 3 is stopped. Then, with the inside of the process chamber 3 evacuated, the source gas is supplied from the supply source (not shown) to each of the gas introduction nozzles 31 through the collecting pipe 30, and this source gas is introduced into the process chamber 3 through each of the outlets 42 (a source gas supplying step). The source gas introduced into the process chamber 3 at this time is, for example, gas in which hydrogen gas, argon gas, etc. are further added to a carbon-based compound. The carbon-based compound includes one kind or two kinds of hydrocarbon compound which is low-boiling liquid or gas at room temperature and normal pressure, for example, methane ($CH_4$), acetylene ($C_2H_2$) or benzene ($C_6H_6$).

Then, plasma is generated inside the process chamber 3 by producing a potential difference between the partition wall 2 and the base table 5. This plasma generation produces ions or radicals from the source gas inside the process chamber 3 and also, the ions or radicals are attracted to the surface 201 of the base material 200 based on the potential difference. Then, a chemical reaction occurs on the surface 201 of the base material 200, and the DLC film 21 is deposited on the intermediate layer 22 (a DLC film depositing step). Accordingly, the coating member 20 in which at least a part of the base material 200 is coated with the DLC film 21 is formed.

Fig. 5 is a graph showing one example of a waveform of a DC pulse voltage applied to the base material 200 from the plasma power source 8. A set voltage value of the DC pulse voltage is set at a value of, for example, about 1000 V. That is, when the plasma power source 8 is turned on, a potential difference of 1000 V occurs between the partition wall 2 and the base table 5. In other words, the negative DC pulse voltage of 1000 V is applied to the base material 200 set inside the process chamber 3 as described above. Since the waveform has a pulse shape, even when such a high voltage is applied, an abnormal electric discharge does not occur inside the process chamber 3 and an increase in temperature of the base material 200 can be reduced to decrease a process temperature to a low temperature of, for example, 300 °C or less.

In the DC pulse voltage, a value obtained by dividing a pulse width $\tau$ by a pulse period expressed by the reciprocal (1/f) of a frequency f, that is, a duty ratio found as a value obtained by multiplying the pulse width $\tau$ by the frequency f as shown in Formula (1) is preferably set at 5% or more, particularly about 10%. Also, the frequency f is preferably set at values from 200 to 2000 Hz (both inclusive), particularly about 1000 Hz.

$$\text{Duty Ratio} = \tau \times f \quad \ldots \quad (1)$$

At a point in time when the DLC film depositing step is performed and the DLC film 21 having a predetermined film thickness is deposited on the base material 200, the plasma power source 8 is turned off and also introduction of the source gas is stopped and then the inside of the process chamber 3 is cooled to room temperature while continuing exhaust by the first pump 17. Then, the first opening/closing valve 15 is closed and instead, a leak valve (not shown) is opened and outside air is introduced into the process chamber 3 and the inside of the process chamber 3 is returned to normal pressure and then, the base material 200 is taken out of the process chamber 3. Accordingly, the coating member 20 in which at least a part of the surface 201 of the base material 200 is coated with the DLC film 21 is manufactured.

Fig. 6 is a sectional view of a surface layer portion of a surface of the coating member 20.

The coating member 20 is used as, for example, a slide member or an ornament. The slide member includes, for example, a clutch plate of a friction clutch, a worm of a steering apparatus (the DLC film 21 is deposited on a tooth surface), a cage or inner and outer rings of a bearing (the DLC film 21 is deposited on a raceway surface), and a propeller shaft (the DLC film 21 is deposited on a driving shaft, a male spline part and/or a female spline part).

The coating member 20 includes the base material 200, the intermediate layer 22 with which the surface 201 of the base material 200 is covered, and the DLC film 21 with which a surface of the intermediate layer 22 is covered. Each of the intermediate layer 22 and the DLC film 21 is a thin film with a film thickness of about several to several tens of micrometers ($\mu$m). A surface of the DLC film 21 forms at least a part of the outermost surface of the coating member 20. When the coating member 20 is used as the slide member, the surface of the DLC film 21 functions as a sliding surface sliding on the other member. Also, when the coating member 20 is used as the slide member, materials of the base material 200 are, for example, iron and steel materials (tool steel, carbon steel and stainless steel), alloy and cemented carbide.

Also, the intermediate layer 22 is a thin film including Si or a metal film such as CrN or TiN.

Next, Example 1 and Comparative Example 1 will be described.

In Example 1, using the plasma CVD film deposition apparatus 1 shown in Fig. 1, the ion bombardment process described above was performed on the surface (peripheral surface) 201 of the base material 200 made of iron and steel material (for example, SCM415) and then, an intermediate layer forming step and a DLC film depositing step were performed in this order and the intermediate layer 22 and the DLC film 21 were deposited.

In Example 1, outside diameters D1, D2, D3 (see Fig. 4) of the first, second and third portions 36, 37, 38 are respectively set at, for example, 12.25 mm, 9.62 mm and 6.35 mm. Also, thicknesses (see Fig. 4) of pipe walls in the first, second and third portions 36, 37, 38 are, for example, 0.8 mm.

Also, a distance L1 (see Fig. 4), a distance L2 (see Fig. 4) and a distance L3 (see Fig. 4) are respectively set at, for example, 60 mm, 50 mm and 50 mm. Also, a distance L4 (see Fig. 4), a distance L5 (see Fig. 4) and a distance L6 (see Fig. 4) are respectively set at, for example, 60 mm, 25 mm and 25 mm. Further, lengths L7, L8, L9 (see Fig. 4) in a direction of the pipe axis are respectively set at 170 mm, 150 mm and 150 mm.

In Comparative Example 1, using the following plasma CVD film deposition apparatus 101, the ion bombardment process described above was performed on the surface (peripheral surface) 201 of the base material 200 made of iron and steel material (for example, SCM415) and then, an intermediate layer depositing step and a DLC film depositing step were performed in this order and an intermediate layer and a DLC film were formed.

In Example 1 and Comparative Example 1, mixed gas of hydrogen gas and argon gas was used as source gas in the ion bombardment process, and a two-component flow rate ratio of hydrogen gas to argon gas was set at 1:1.

In Example 1 and Comparative Example 1, mixed gas of methane, hydrogen gas, argon gas as a carbon-based compound and TMS as gas including Si was used as source gas in the intermediate layer forming step, and a four-component flow rate ratio of methane to hydrogen gas to argon gas to TMS was set at 0.5-1:0.5-1:0.5-1:0.03-0.06.

In Example 1 and Comparative Example 1, mixed gas of methane, hydrogen gas, argon gas as a carbon-based compound and TMS as gas including Si was used as source gas in the DLC film depositing step, and a four-component flow rate ratio of methane to hydrogen gas to argon gas to TMS was set at 0.6:0.6:1:0.03.

The flow rate ratios of the source gas in each of the steps of Example 1 and Comparative Example 1 are shown in the following Table 1.

[Table 1]

Table 1

| Gas | Ion Bombardment Process | Intermediate Layer Forming Step | DLC Film Forming Step |
|---|---|---|---|
| Ar | 1 | 0.5 - 1 | 0.6 |
| $H_2$ | 1 | 0.5 - 1 | 0.6 |
| $CH_4$ | 0 | 0.5 - 1 | 1 |
| TMS | 0 | 0.03 - 0.06 | 0.03 |

A set voltage value of a DC pulse voltage was set at, for example, -1000 V, and a frequency f was set at, for example, 1000 Hz, and a duty ratio was set at, for example, 10%.

Fig. 7 is a schematic diagram showing a configuration of a gas introduction nozzle 131 of the plasma CVD film deposition apparatus 101 of Comparative Example 1. In Fig. 7, the explanation is omitted by assigning the same reference numerals to the portions common to those of the plasma CVD film deposition apparatus 1 described above.

The plasma CVD film deposition apparatus 101 of Comparative Example 1 includes the four gas introduction nozzles 131 formed mutually rotationally symmetrically about collecting pipe 30. Each of the gas introduction nozzles 131 has a horizontal part 133 and a vertical part 134, and includes gas introduction pipe 132 connected to the downstream end of the collecting pipe 30. A cylindrical gas flow path 135 communicating with the inside of the collecting pipe 30 is defined in each gas introduction pipe 132, and each gas flow path 135 is closed in the downstream end of the vertical part 134. The vertical parts 134 are respectively arranged in four corners of a rectangular shape in plain view in a process chamber 3. The lower end of each gas introduction nozzle 131, that is, the lower end of each vertical part 134 is located in the lateral side of a base table 5. A pipe diameter of the vertical part 134 is constant in a direction of the pipe axis and is, for example, 6.35 mm.

As shown in Fig. 7, a plurality of (for example, nine) outlets 142 for discharging source gas are formed in a peripheral surface of each vertical part 134. The plurality of (for example, four) outlets 142 for discharging source gas are formed in a peripheral surface of each horizontal part 133. These outlets 142 are arranged along the direction of the pipe axis of each gas introduction pipe 132.

Also, in each horizontal part 133, the outlets 142 are spaced by a predetermined distance L11 (for example, 50 mm). Each of the outlets 142 is formed in the peripheral surface of the horizontal part 133 in the lowermost position in a circumferential direction of the peripheral surface. A distance L14 between the downstream end of the collecting pipe 30 and the outlet 142 of the most upstream side in the horizontal part 133 is, for example, 35 mm, and a distance L15 between the downstream end of the horizontal part 133 and the outlet 142 of the most downstream side in the horizontal part 133 is, for example, 50 mm.

In each vertical part 134, the outlets 142 are spaced by a predetermined distance (half of L12 shown in Fig. 7, for example, 50 mm). The outlets 142 formed in the vertical part 134 have a first outlet 142A for discharging source gas toward a predetermined first transverse direction, and a second outlet 142B for discharging the source gas toward a second transverse direction 90° out of phase with the first transverse direction in a circumferential direction of the cylindrical vertical part 134. The first transverse direction is an inward transverse direction (horizontal direction) along one side surface of two side surfaces of a partition wall 2 forming the corners in which the vertical parts 134 are stored, and the second transverse direction is an inward transverse direction (horizontal direction) along the other side surface of two side surfaces of the partition wall 2 forming the corners in which the vertical parts 134 are stored.

The first outlet 142A and the second outlet 142B are alternately arranged in the direction of the pipe axis of each vertical part 134. A distance L16 between the downstream end of the horizontal part 133 and the outlet 142 of the most upstream side in the vertical part 134 is, for example, 50 mm.

Fig. 8 is a diagram showing base material height direction (direction perpendicular to an upper surface of the plate 9 (see Fig. 1 etc.)) distribution of film thicknesses of DLC films deposited by the plasma CVD film deposition apparatus 1 of Example 1 and the plasma CVD film deposition apparatus 101 of Comparative Example 1. The axis of abscissa of Fig. 8 is a base material height direction position (distance) from the lower end (that is, the upper surface of the plate 9) of the base material 200 (see Fig. 1 etc.).

From Fig. 8, it is understood that the thicknesses of the DLC films 21 (see Fig. 6 etc.) are substantially uniform in a base material height direction in Example 1.

On the other hand, it is understood that the thicknesses of the DLC films are thinner as the distance is separate from the lower end of the base material 200 in Comparative Example 1.

The embodiment of this invention has been described above, but this invention is not limited to the contents of the embodiment described above, and various changes can be made within the scope described in the claims.

For example, the case where the vertical part 34 has the three-step shape is taken as an example, but the vertical part 34 may have a two-step shape or a shape with four or more steps.

Also, in the above explanation, the outlet 42 is not formed in the horizontal part 33, but it may be configured to arrange the outlet 42 in the horizontal part 33. However, in order to maintain a pressure of source gas in each place of the vertical part 34 (particularly, the upstream portion of the vertical part 34) high and discharge the source gas from each of the outlets 42 of the vertical part 34 (particularly, each of the outlets 42 of the upstream portion of the vertical part 34) in a rushing manner, it is desirable that the outlet 42 be not formed in the horizontal part 33.

Also, in the above explanation, the configuration of forming the first outlet 42A and the second outlet 42B with mutually different discharge directions as the outlets 42 of the vertical part 34 is illustrated, but the configuration of each of the outlets 42 having the common discharge direction may be used. However, in order to evenly spread the source gas in each place of the inside of the process chamber 3, it is desirable to form two kinds of the first and second outlets 42A, 42B as the outlets 42 of the vertical part 34.

Also, the case of being directly opened in the pipe wall of the gas introduction pipe 32 as each of the outlets 42 is illustrated, but the outlet may be formed in the top of a nozzle (for example, a cylindrical nozzle) attached to the gas introduction pipe 32.

Also, the DLC film 21 is taken as one example of the carbon film, but other carbon films can also be adopted.

In the plasma CVD film deposition apparatus 1, the film deposition apparatus for depositing the carbon film by the DC pulse plasma CVD method is taken as an example, but the invention can also be applied to a film deposition apparatus for depositing the carbon film by a DC plasma CVD method. Further, the invention can be applied to a film deposition apparatus for depositing the carbon film using methods other than the CVD methods.

Moreover, various design changes can be made within the scope of the items described in the claims.

A first aspect of an embodiment of the invention provides a carbon film deposition apparatus (1) for depositing a carbon film (21) on a surface (201) of a base material (200), including: a process chamber (3); base material holding means (5) which is stored in the process chamber and which holds the base material; a nozzle (31) which has a plurality of outlets (42) for discharging source gas into the process chamber, and which includes a gas introduction pipe (32) defining therein a gas flow path (35) communicating with each of the plurality of outlets; and source gas supply means for supplying the source gas containing a carbon-based compound to the gas introduction pipe, wherein a portion of a pipe wall of the gas introduction pipe corresponding to formation regions of the plurality of outlets is formed to have a stepped shape such that diameters (D1, D2, D3) of the gas flow path of the pipe wall become smaller as a distance from a side of supply of source gas by the source gas supply means increases.

A second aspect provides the carbon film deposition apparatus according to the first aspect, wherein the gas introduction pipe includes a horizontal part (33) formed on the side of supply of the source gas and which extends horizontally, and a vertical part (34) which is formed on a side opposite to the side of supply of the source gas and which extends vertically, wherein the vertical part has the plurality of outlets, and wherein the plurality of outlets are not formed in the horizontal part.

In a third aspect, the plurality of outlets have a first outlet (42A) which discharges the source gas toward a given first discharge direction perpendicular to a pipe axial direction of the gas introduction pipe, and a second outlet (42B) which discharges the source gas toward a given second discharge direction which is perpendicular to the pipe axial direction and which is different from the first discharge direction. In addition, the first and second outlets may be alternately arranged in the pipe axial direction.

A fourth aspect provides the carbon film deposition apparatus according to any one of the first to third aspects, wherein the process chamber includes a partition wall (2) formed using a conductive material, and wherein the base material holding means includes a base table (5) which supports the base material and which is formed using a conductive material, wherein the carbon film deposition apparatus further includes a plasma power source (8) which generates a DC voltage (including a DC pulse voltage) between the partition wall and the base table and which turns the source gas introduced into the process chamber into plasma.

A fifth aspect provides a carbon film deposition method for depositing a carbon film (21) on a surface (201) of a base material (200), including: a base material holding step of holding the base material in base material holding means (5) stored in a process chamber (3); and a source gas supplying step of supplying source gas including a carbon-based compound from source gas supply means to a gas introduction pipe of a nozzle (31) which has a plurality of outlets (42) opened in the process chamber, and which includes the gas introduction pipe (32) defining therein a gas flow path (35) communicating with each of the plurality of outlets, wherein a portion of a pipe wall of the gas introduction pipe corresponding to formation regions of the plurality of outlets is formed to have a stepped shape such that diameters (D1, D2, D3) of the gas flow path of the pipe wall become smaller as a distance from a side of supply of source gas by the source gas supply means increases.

According to the configuration of the first aspect, a portion of the pipe wall of the gas introduction pipe corresponding to the formation regions of the outlets is formed to have the stepped shape such that the diameters of the gas flow paths of the pipe wall become smaller as a distance from the side of supply of source gas increases. Consequently, the step portions interfere with the source gas passing through the gas flow path. As a result, the source gas can be caused to overflow to the gas flow path of the side of supply of the source gas and also, the source gas is inhibited from being supplied to the gas flow path of the side opposite to the side of supply of the source gas. Accordingly, a discharge flow rate of the source gas from each of the outlets can be made uniform, with the result that a source gas concentration in each place of the inside of the process chamber can be made uniform. Accordingly, a carbon film with a uniform thickness can be deposited on the surface of the base material.

According to the configuration of the second aspect, the outlet is not formed in the horizontal part, and the outlets are formed in only the perpendicular part. Since the outlet is not formed in the horizontal part, a pressure of the source gas in each place of the perpendicular part (particularly, the side of supply of the source gas in the perpendicular part) can be maintained high and the source gas can be discharged from each of the outlets in a rushing manner.

According to the configuration of the third aspect, the first outlet for discharging the source gas toward the first discharge direction and the second outlet for discharging the source gas toward the second discharge direction are alternately arranged in the direction of the pipe axis of the gas introduction pipe. As a result, the source gas can evenly be spread in each place of the inside of the process chamber even when the number of pieces of gas introduction pipe stored and arranged in the process chamber is small. Accordingly, the source gas concentration in each place of the inside of the process chamber can be made more uniform.

According to the configuration of the fourth aspect, by changing the source gas into the plasma state inside the process chamber, film deposition process to the base material by a plasma CVD method is performed. Since the source gas concentration in each place of the inside of the process chamber is uniform, the carbon film with the uniform thickness can be deposited on the surface of the base material.

The method of the fifth aspect has the action and effect equal to those described in connection with the first aspect.

## Description of Reference Signs

1: PLASMA CVD FILM DEPOSITION APPARATUS

| | |
|---|---|
| 2: | PARTITION WALL |
| 3: | PROCESS CHAMBER |
| 5: | BASE TABLE (BASE MATERIAL HOLDING MEANS) |
| 8: | PLASMA POWER SOURCE |
| 21: | DLC FILM (CARBON FILM) |
| 31: | GAS INTRODUCTION NOZZLE (NOZZLE) |
| 32: | GAS INTRODUCTION PIPE |
| 33: | HORIZONTAL PART |
| 34: | VERTICAL PART |
| 35: | GAS FLOW PATH |
| 42: | OUTLET |
| 42A: | FIRST OUTLET |
| 42B: | SECOND OUTLET |
| 200: | BASE MATERIAL |
| 201: | SURFACE |
| D1, D2, D3: | FLOW PATH DIAMETER |

**Claims**

**1.** A carbon film deposition apparatus for depositing a carbon film on a surface of a base material, comprising:

a process chamber;
base material holding means which is stored in the process chamber and which holds the base material;
a nozzle which has a plurality of outlets for discharging source gas into the process chamber, and which comprises a gas introduction pipe defining therein a gas flow path communicating with each of the plurality of outlets; and
source gas supply means for supplying the source gas containing a carbon-based compound to the gas introduction pipe,
wherein a portion of a pipe wall of the gas introduction pipe corresponding to formation regions of the plurality of outlets is formed to have a stepped shape such that diameters of the gas flow path of the pipe wall become smaller as a distance from a side of supply of source gas by the source gas supply means increases.

**2.** The carbon film deposition apparatus according to claim 1,
wherein the gas introduction pipe comprises a horizontal part formed on the side of supply of the source gas and which extends horizontally, and a vertical part which is formed on a side opposite to the side of supply of the source gas and which extends vertically,
wherein the vertical part has the plurality of outlets, and
wherein the plurality of outlets are not formed in the horizontal part.

**3.** The carbon film deposition apparatus according to claim 1 or 2,
wherein the plurality of outlets have a first outlet which discharges the source gas toward a given first discharge direction perpendicular to a pipe axial direction of the gas introduction pipe, and a second outlet which discharges the source gas toward a given second discharge direction which is perpendicular to the pipe axial direction and which is different from the first discharge direction.

**4.** The carbon film deposition apparatus according to any one of claims 1 to 3,
wherein the process chamber comprises a partition wall formed using a conductive material,
wherein the base material holding means comprises a base table which supports the base material and which is formed using a conductive material, and
wherein the carbon film deposition apparatus further comprises a plasma power source which generates a DC voltage between the partition wall and the base table and which turns the source gas introduced into the process chamber into plasma.

**5.** A carbon film deposition method for depositing a carbon film on a surface of a base material, comprising:

a base material holding step of holding the base material in base material holding means stored in a process chamber; and

a source gas supplying step of supplying source gas comprising a carbon-based compound from source gas supply means to a gas introduction pipe of a nozzle which has a plurality of outlets opened in the process chamber, and which comprises the gas introduction pipe defining therein a gas flow path communicating with each of the plurality of outlets,
wherein a portion of a pipe wall of the gas introduction pipe corresponding to formation regions of the plurality of outlets is formed to have a stepped shape such that diameters of the gas flow path of the pipe wall become smaller as a distance from a side of supply of source gas by the source gas supply means increases.

FIG. 1

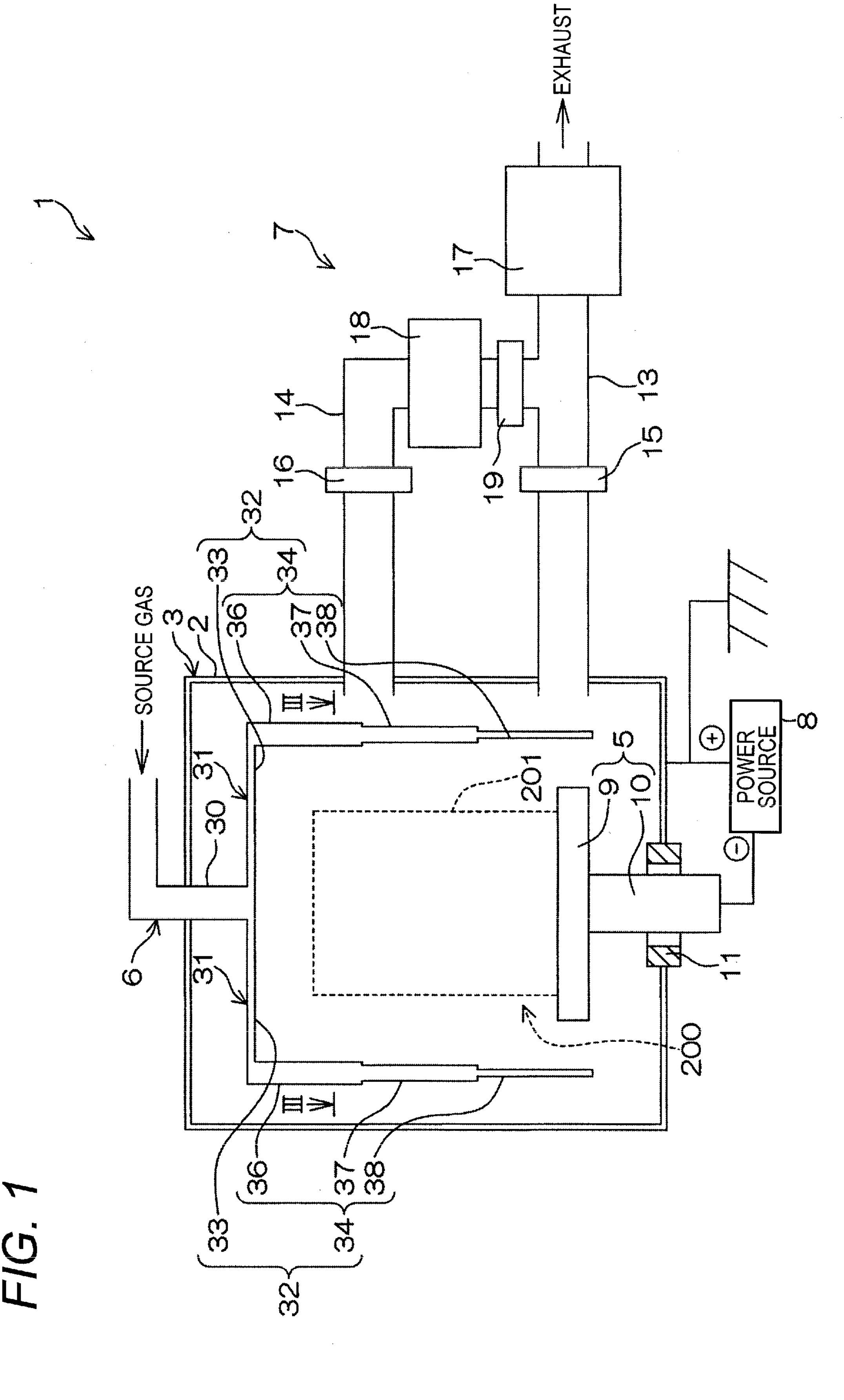
EXHAUST
SOURCE GAS
POWER SOURCE
+
−
1
2
3
5
6
7
8
9
10
11
13
14
15
16
17
18
19
30
31
32
33
34
36
37
38
200
201
III

FIG. 2

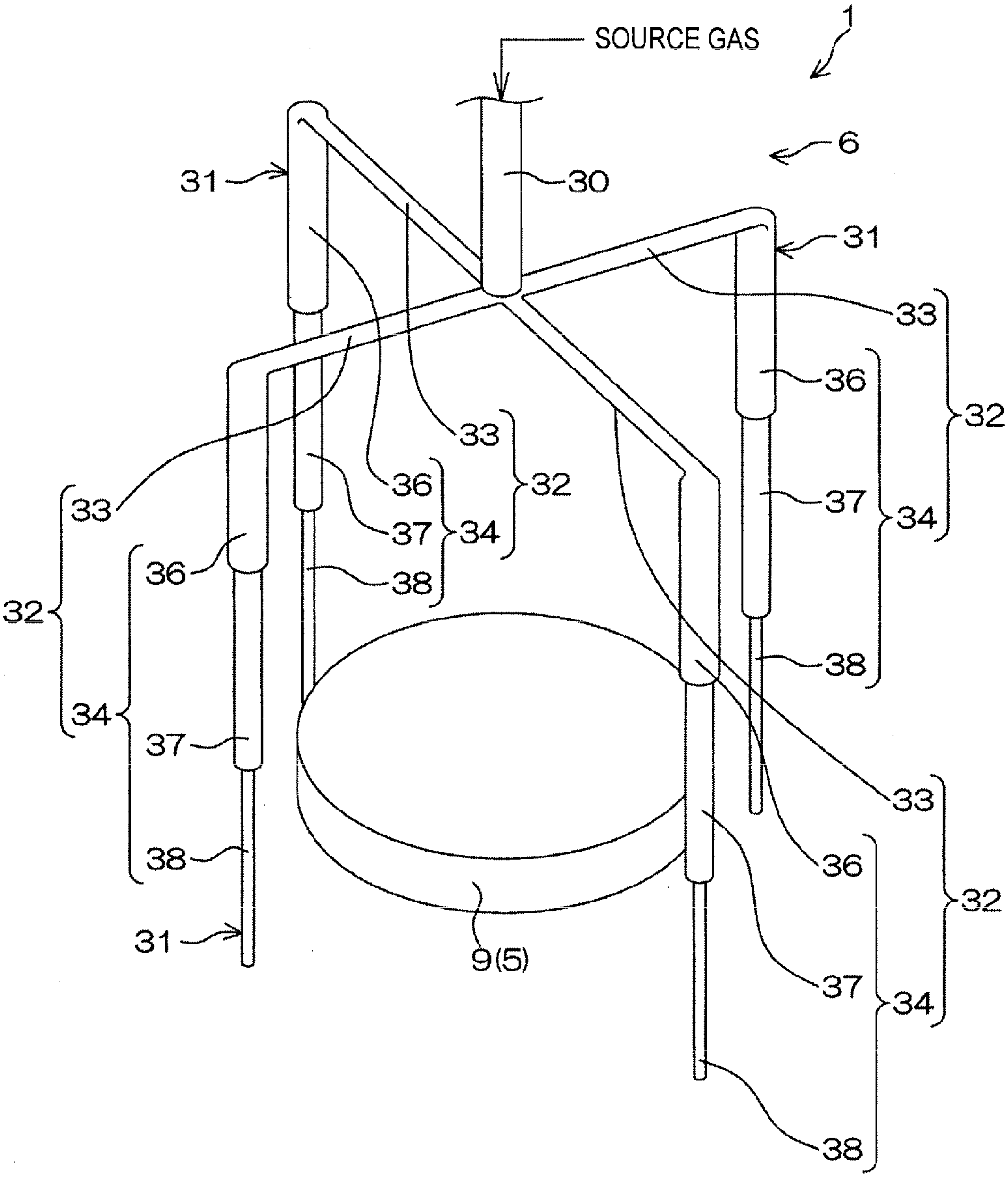
SOURCE GAS
1
6
30
31
31
33
32
33
36
36
33
32
37
34
34
37
33
32
36
36
38
38
32
34
33
37
32
38
36
31
9(5)
37
34
38

FIG. 3

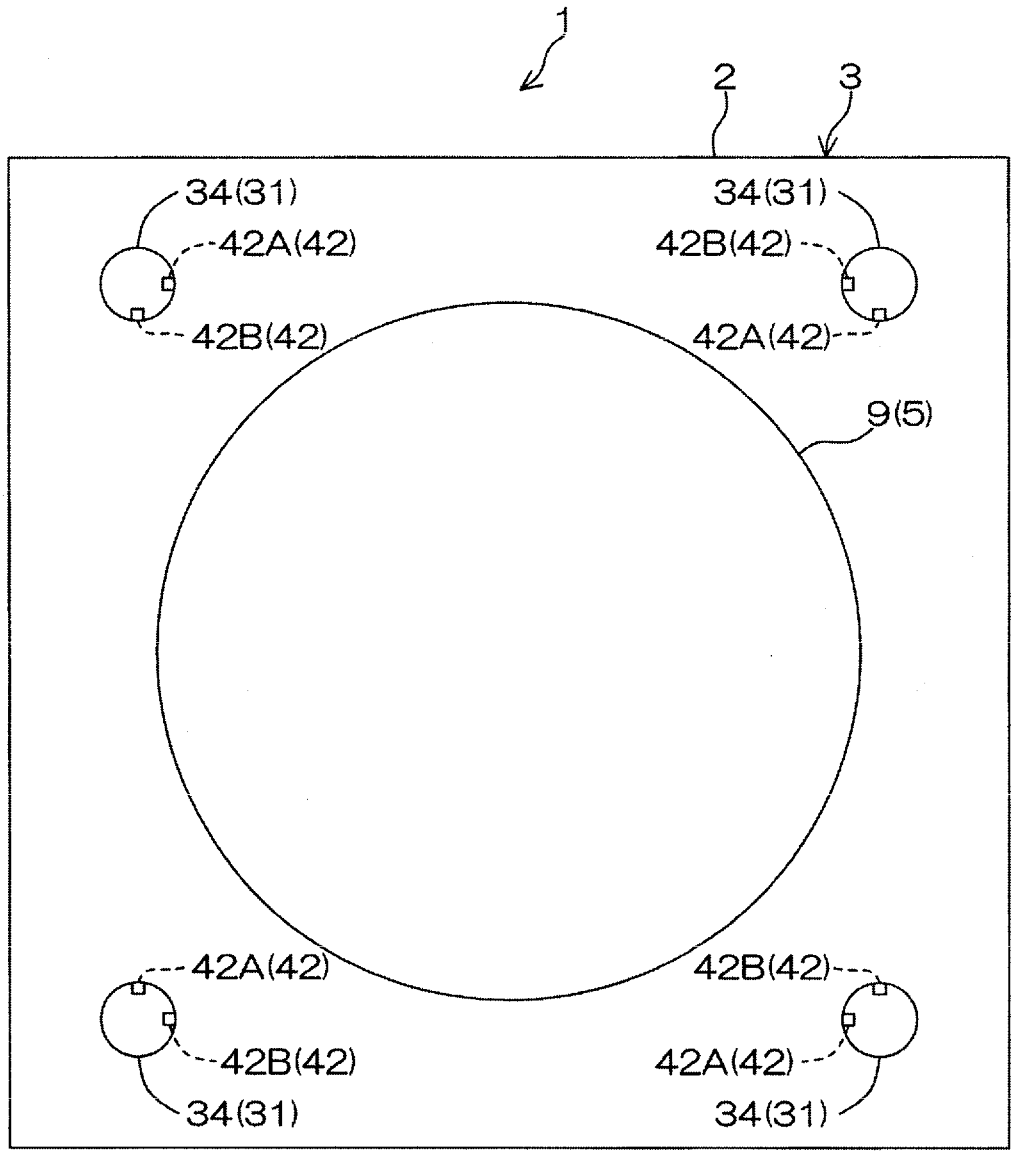
1
2
3
34(31)
42A(42)
42B(42)
34(31)
42B(42)
42A(42)
9(5)
42A(42)
42B(42)
34(31)
42B(42)
42A(42)
34(31)

FIG. 4

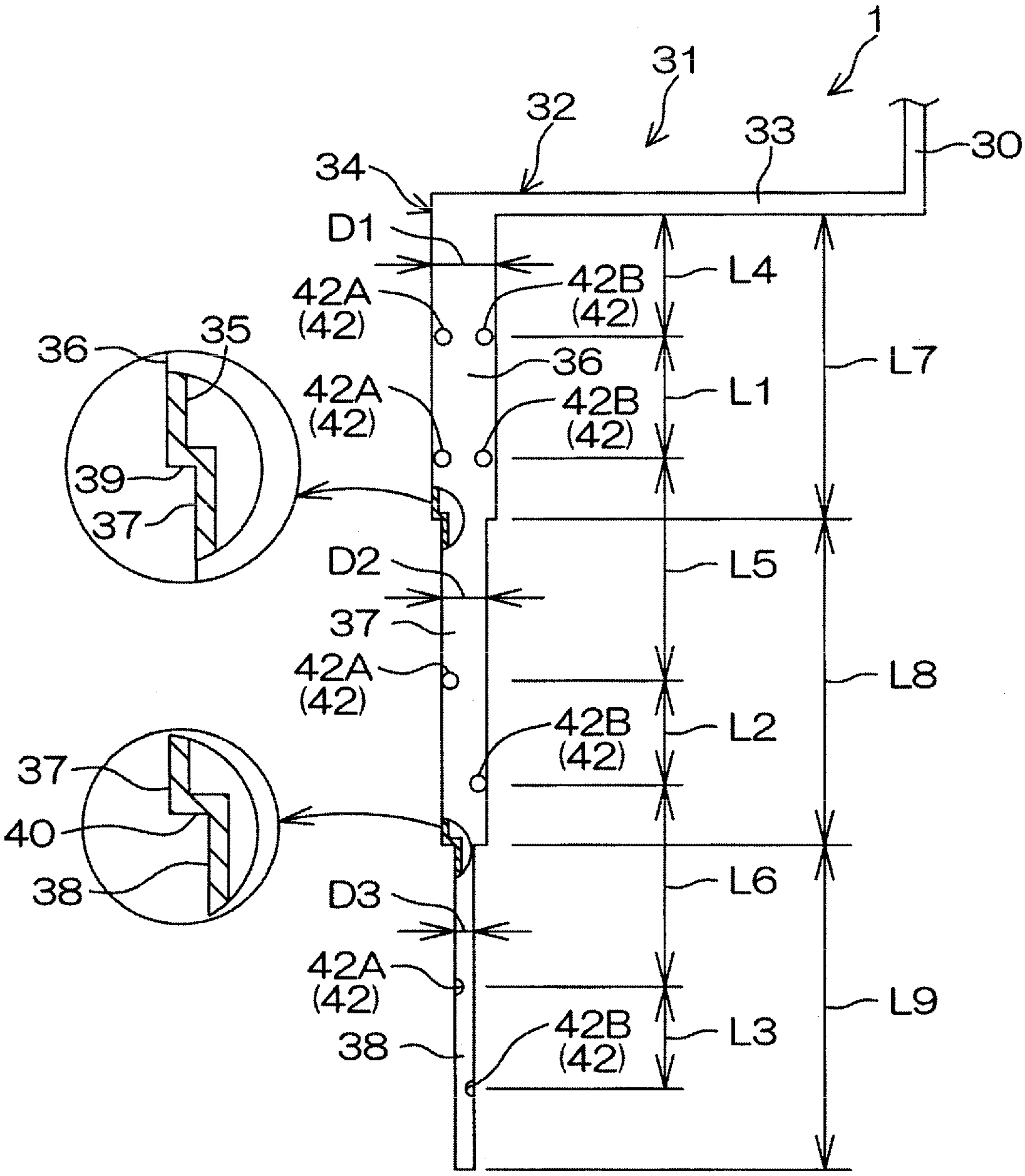
1
31
32
33
30
34
D1
42A
(42)
42B
(42)
L4
36
35
36
L7
42A
(42)
42B
(42)
L1
39
37
D2
L5
37
42A
(42)
L8
42B
(42)
L2
37
40
38
L6
D3
42A
(42)
L9
38
42B
(42)
L3

FIG. 5

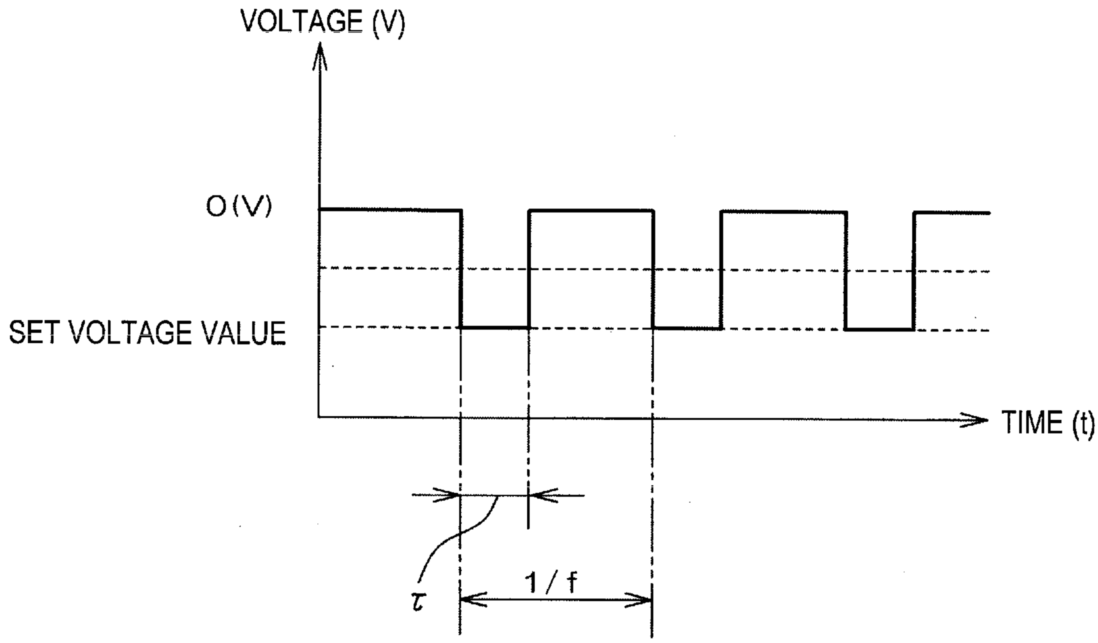


FIG. 6

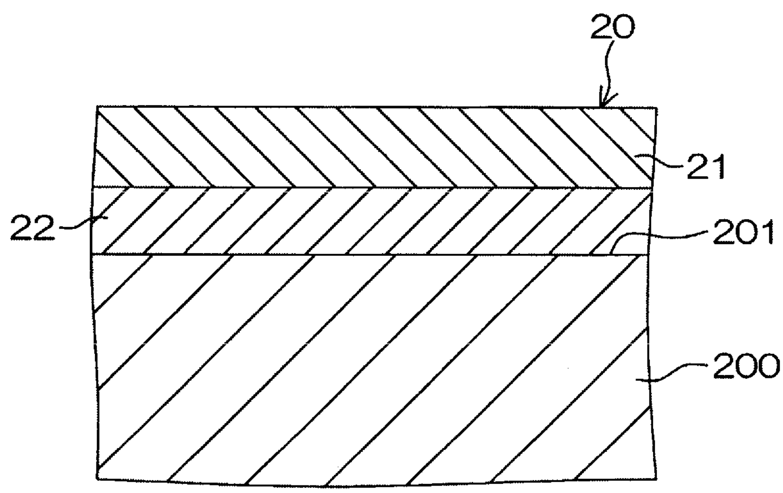

*FIG. 7*

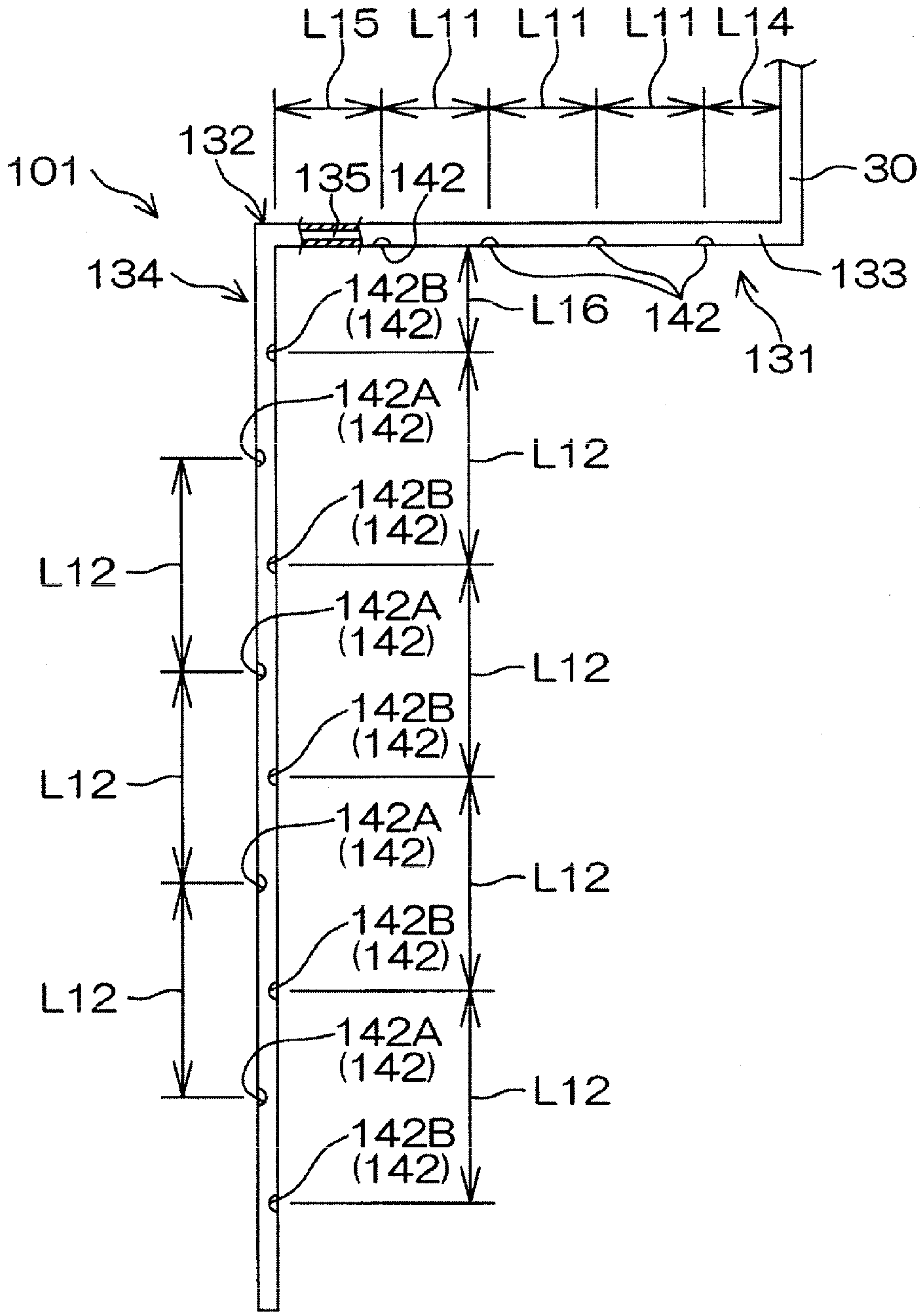
L15
L11
L11
L11
L14
132
101
135
142
30
134
133
142B
(142)
L16
142
131
142A
(142)
L12
142B
(142)
L12
142A
(142)
L12
142B
(142)
L12
142A
(142)
L12
142B
(142)
L12
142A
(142)
L12
142B
(142)

FIG. 8

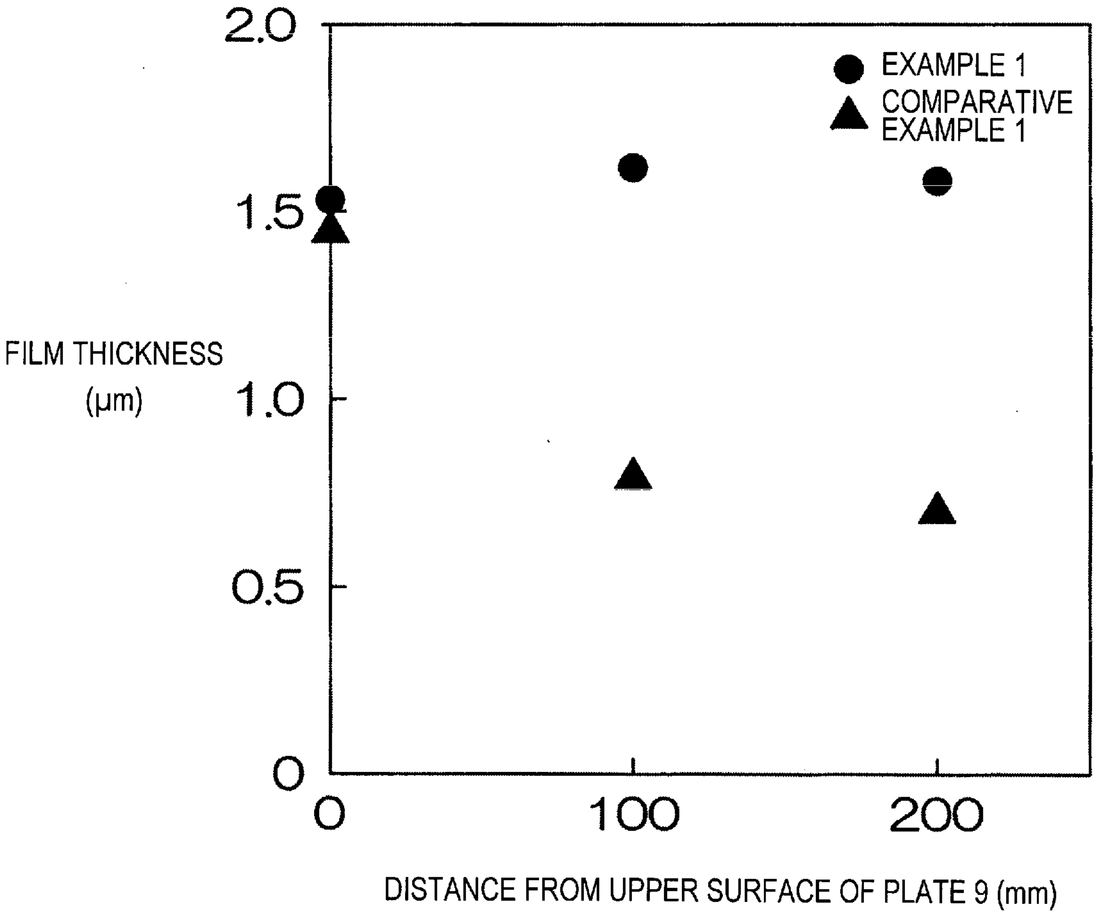
2.0
1.5
1.0
0.5
0
FILM THICKNESS
(μm)
EXAMPLE 1
COMPARATIVE
EXAMPLE 1
0
100
200
DISTANCE FROM UPPER SURFACE OF PLATE 9 (mm)

## INTERNATIONAL SEARCH REPORT

International application No.
PCT/JP2013/052868

A. CLASSIFICATION OF SUBJECT MATTER
*C23C16/455*(2006.01)i, *C01B31/02*(2006.01)i, *C23C16/27*(2006.01)i

According to International Patent Classification (IPC) or to both national classification and IPC

B. FIELDS SEARCHED

Minimum documentation searched (classification system followed by classification symbols)
C23C16/455, C01B31/02, C23C16/27

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)
WPI

C. DOCUMENTS CONSIDERED TO BE RELEVANT

| Category* | Citation of document, with indication, where appropriate, of the relevant passages | Relevant to claim No. |
|---|---|---|
| A | JP 2003-017422 A (F.T.L. Co., Ltd.), 17 January 2003 (17.01.2003), paragraphs [0020], [0034]; fig. 5 & US 2003/0186517 A1 & US 2009/0283216 A1 & TW 236705 B | 1-5 |
| A | JP 2005-142448 A (Shimadzu Corp.), 02 June 2005 (02.06.2005), paragraphs [0014], [0019]; fig. 4 & US 2005/0109279 A1 & TW 249975 B & KR 10-2005-0044248 A & CN 1614086 A | 1-5 |
| A | JP 2000-294511 A (F.T.L. Co., Ltd.), 20 October 2000 (20.10.2000), paragraph [0036] (Family: none) | 1-5 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 26 February, 2013 (26.02.13) | 12 March, 2013 (12.03.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

INTERNATIONAL SEARCH REPORT

International application No.
PCT/JP2013/052868

C (Continuation). DOCUMENTS CONSIDERED TO BE RELEVANT

| Category* | Citation of document, with indication, where appropriate, of the relevant passages | Relevant to claim No. |
|---|---|---|
| A | WO 2005/015619 A1 (Hitachi Kokusai Electric Inc.), 17 February 2005 (17.02.2005), paragraphs [0017], [0022], [0025]; fig. 1 & JP 4267624 B & US 2007/0034158 A1 & US 2010/0081288 A1 & KR 10-2005-0117573 A | 1-5 |
| A | JP 2003-045864 A (Hitachi Kokusai Electric Inc.), 14 February 2003 (14.02.2003), paragraphs [0006], [0022], [0029], [0030]; fig. 1, 3 & US 2003/0024477 A1 & KR 10-2003-0013303 A | 1-5 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2011252179 A